Europäisches Patentamt

European Patent Office

Office européen des brevets

(19)

(11) **EP 0 823 805 A1**

(12) # DEMANDE DE BREVET EUROPEEN

(43) Date de publication:
**11.02.1998 Bulletin 1998/07**

(51) Int Cl.6: **H04L 27/36**

(21) Numéro de dépôt: **97401870.7**

(22) Date de dépôt: **04.08.1997**

(84) Etats contractants désignés:
**AT BE CH DE DK ES FI FR GB GR IE IT LI LU MC
NL PT SE**

(30) Priorité: **07.08.1996 FR 9609949**

(71) Demandeur: **ALCATEL TELSPACE
92734 Nanterre Cédex (FR)**

(72) Inventeur: **Marchesani, Rossano
66100 Chieti (IT)**

(74) Mandataire: **Scheer, Luc et al
c/o Alcatel Alsthom Recherche,
DPI,
30 Avenue Kléber
75016 Paris (FR)**

(54) **Procédé et dispositif de modélisation des caractéristiques AM/AM et AM/PM d'un
amplificateur, et procédé de prédistorsion correspondant**

(57)     L'invention concerne un procédé de modélisation des caractéristiques AM/AM et AM/PM d'un amplificateur, comprenant les étapes suivantes :

- transmission (11) d'un signal de référence audit amplificateur;
- numérisation (13) de la réponse dudit amplificateur audit signal de référence, de façon à produire deux ensembles d'échantillons de référence AM/AM et AM/PM respectivement ;

- détermination (14) de deux séries de polynômes représentatifs respectivement desdites caractéristiques AM/AM et AM/PM, à partir desdits échantillons, tenant compte d'une part de la dérivée seconde dudit polynôme, et d'autre part des distances entre lesdits échantillons et les points de la courbe définie par le polynôme.

Il est ainsi possible d'obtenir des caractéristiques lissées.

Fig. 6

## Description

Le domaine de l'invention est celui de l'émission de signaux modulés à l'aide d'une modulation à enveloppe non constante. Plus précisément, l'invention concerne la prédistorsion de tels signaux, avant leur émission.

L'invention s'applique ainsi, notamment, aux modulations de type QPSK ou QAM. L'invention a été plus particulièrement développée pour le standard TETRA (Trans European Trunk Radio System) de radiocommunication professionnelle avec les mobiles (en anglais, PMR : Private Mobile Radio) destiné par exemple aux réseaux utilisés par les services de pompier, de police, de taxi, etc...

Le système TETRA met en oeuvre une modulation de type $\pi/4$ - DQPSK, dans les stations de base (BTS).

Les modulations à enveloppe non constante imposent un fonctionnement sur une grande plage de la dynamique de l'amplificateur (contrairement aux modulations à enveloppe constante). Elles imposent donc une grande variation de la réponse en puissance de l'amplificateur, ce qui induit des phénomènes de distorsion.

Ce problème est bien connu. Pour le combattre, on applique une prédistorsion au signal, avant son amplification. Cette prédistorsion doit être calculée de façon qu'elle compense le mieux possible la distorsion induite par l'amplificateur, afin que le signal résultant soit le moins possible détérioré par la distorsion.

Diverses techniques de prédistorsion sont déjà connues. Il existe notamment une méthode analogique, connue sous le nom de "cartesian feedback" (rétro-action cartésienne), et une méthode auto-adaptative.

La prédistorsion à appliquer peut également être calculée par la méthode du "spline". Cette technique est notamment décrite dans l'ouvrage de C. de Boor "A practical guide to splines" ("guide pratique du spline"), Springer Verlag, 1978.

Cette technique a pour but la détermination des caractéristiques AM/AM (amplitude) et AM/PM (phase) de l'amplificateur, afin de contrôler la prédistorsion à appliquer.

Pour cela, on transmet à l'amplificateur un signal de référence (un signal deux tons, dans le cas de TETRA), on numérise la réponse de l'amplificateur, de façon à produire une série d'échantillons, puis on modélise les caractéristiques AM/AM et AM/PM par spline.

Cette modélisation consiste en la réalisation d'une courbe en reliant deux échantillons successifs par interpolation cubique. En d'autres termes, on applique une fenêtre glissante sur les échantillons, sélectionnant quatre points consécutifs, et on recherche, pour les deux points centraux, le polynôme définissant la courbe passant par ces quatre points et dont la dérivée seconde est minimisée.

Cette technique présente plusieurs inconvénients.

Notamment, la modélisation ainsi obtenue s'avère relativement sensible aux défauts de quadrature et de balance, ainsi qu'au bruit de phase en fréquence intermédiaire (F.I.).

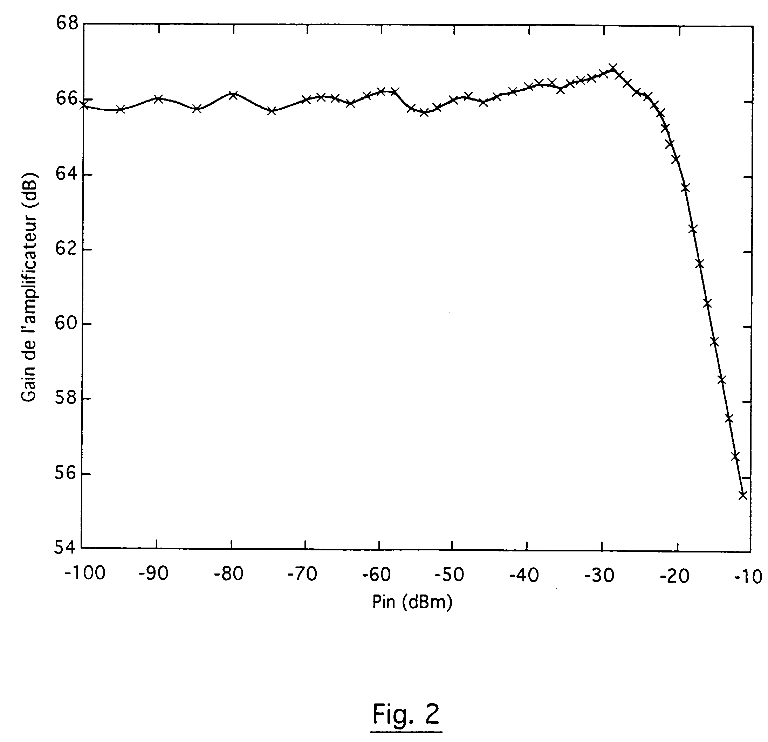

La courbe de modélisation obtenue (voir la figure 2, discutée plus loin) est généralement très "mouvementée", en présence d'erreurs de mesure, de façon à passer par tous les échantillons produits.

L'invention a notamment pour objectifs de pallier ces différents inconvénients de l'état de la technique.

Plus précisément, un objectif de l'invention est de fournir un procédé de modélisation des caractéristiques AM/AM et AM/PM d'un amplificateur.

Un autre objectif de l'invention est de fournir un tel procédé, qui permette de lisser les courbes calculées, par rapport à la technique classique du spline.

Encore un autre objectif de l'invention est de fournir un tel procédé, permettant de réduire les émissions parasites dans des canaux adjacents et, notamment, dans le cas du système TETRA, une réjection meilleure que celle requise par la norme.

L'invention a également pour objectif de fournir un tel procédé, limitant la sensibilité :

- aux défauts de quadrature ;
- aux défauts de balance ;
- au bruit de phase en F.I. ;
- aux bruits de toute type.

Un autre objectif de l'invention est de fournir un tel procédé qui puisse remplacer la technique du spline sans nécessiter aucune adaptation de l'émetteur.

Ces objectifs, ainsi que d'autres qui apparaîtront par la suite sont atteints selon l'invention à l'aide d'un procédé de modélisation des caractéristiques AM/AM et AM/PM d'un amplificateur, comprenant les étapes suivantes :

- transmission d'un signal de référence audit amplificateur;
- numérisation de la réponse dudit amplificateur audit signal de référence, de façon à produire deux ensembles d'échantillons de référence AM/AM et AM/PM respectivement ;
- détermination de deux séries de polynômes représentatifs respectivement desdites caractéristiques AM/AM et AM/PM, à partir desdits échantillons,

la détermination de chacun desdits polynômes tenant compte d'une part de la dérivée seconde dudit polynôme, et d'autre part des distances entre lesdits échantillons mesurés et les points de la courbe définie par le polynôme.

De cette façon, il est possible de "lisser" les courbes définies par les polynômes. Ces courbes sont plus efficaces, notamment en termes de réduction des perturbations des canaux adjacents et de sensibilité aux défauts.

L'invention repose sur une approche nouvelle de la modélisation des caractéristiques AM/AM et AM/PM. En effet, selon la technique classique du "spline", l'objectif est de déterminer la meilleure courbe passant par tous les échantillons obtenus à partir du signal de référence. Au contraire, selon l'invention, on autorise la courbe à s'éloigner sensiblement des échantillons, de façon à lisser la courbe.

L'homme du métier considère que les échantillons obtenus sont des références fiables, car dérivés d'un signal de référence connu. Les inventeurs en revanche limitent la confiance accordée à ces échantillons. En effet, ceux-ci apparaissent malgré tout soumis à différentes perturbations pendant leur amplification, et ne sont donc pas complètement exacts.

En d'autres termes, l'invention propose une technique nouvelle, tenant compte du fait que les échantillons de référence sont affectés par les différentes sources de bruit.

De façon préférentielle, chacun desdits polynômes (w) est déterminé pour deux échantillons consécutifs ($P_1$ et $P_2$), et minimise une combinaison linéaire des trois paramètres suivants :

- dérivée seconde (w") dudit polynôme (w) ;
- distance dudit polynôme avec l'échantillon $P_1$ : $d_1^2 = (w_{(P1)} + w)^2$ ;
- distance dudit polynôme avec l'échantillon $P_2$ : $d_2^2 = (w_{(P2)} + w)^2$.

Il est à noté que la prise en compte de la seule dérivée seconde correspond à la technique classique du "spline". La nouveauté de l'invention repose donc sur la prise en compte des distances. En d'autres termes, les réponses AM/AM et AM/PM sont modélisées à l'aide d'une méthode à "spline adaptée" (en anglais : "relaxed spline").

Avantageusement, ladite combinaison linéaire s'écrit :

$$J = \int_{x_1}^{x_N} (w''(x))^2 dx + \frac{1}{\rho} \sum_1^N w(x_i) - y_i)^2$$

où p est un coefficient de pondération.

Selon un mode de réalisation préférentiel de l'invention, ledit coefficient de pondération $\rho$ varie en fonction d'au moins un des paramètres appartenant au groupe comprenant:

- l'erreur de quadrature ;
- l'erreur de balance ;
- la température ;
- les défauts induits par le démodulateur;
- le bruit de phase ;
- le bruit global ;
- la caractéristique moyenne de ladite courbe.

Il apparaît en effet souhaitable, selon les conditions rencontrées, d'augmenter le lissage de la courbe ($\rho$ plus grand, importance des distances augmentées), ou de suivre d'un peu plus prêt les échantillons obtenus ($\rho$ plus petit, importance de la dérivée seconde augmentée).

De façon avantageuse, ladite détermination desdits polynômes met en oeuvre une matrice de calcul pentadiagonale. Cette technique est dérivée de celle décrite par De Boor, dans l'ouvrage précité, et utilisant une matrice tridiagonale pour un "spline" classique.

Dans un mode de réalisation particulier, pouvant notamment être appliqué au système TETRA, ledit signal de référence est constitué de deux fréquences pilotes émises régulièrement, et séparées par une bande de fréquence de battement choisie de façon à couvrir une bande de fréquence très étroite, pour représenter la réponse en bande de base dudit amplificateur, sans perturber les canaux voisins.

Avantageusement, ladite détermination desdits polynômes est utilisée pour mettre à jour une table de prédistorsion.

L'invention concerne également les dispositifs de modélisation des caractéristiques AM/AM et AM/PM d'un amplificateur, mettant en oeuvre le procédé décrit ci-dessus. Un tel dispositif comprend notamment :

- des moyens de numérisation de la réponse dudit amplificateur audit signal de référence, délivrant deux ensembles d'échantillons de référence AM/AM et AM/PM respectivement ; et
- des moyens de détermination de deux séries de polynômes représentatifs respectivement desdites caractéristiques AM/AM et AM/PM, à partir desdits échantillons, tenant compte d'une part de la dérivée seconde dudit polynôme, et d'autre part des distances entre lesdits échantillons et les points de la courbe définie par le polynôme.

L'invention concerne encore un procédé de prédistorsion pour un amplificateur d'un signal modulé selon une modulation à enveloppe non constante, à partir d'une modélisation des caractéristiques AM/AM et AM/PM dudit amplificateur, comprenant les étapes suivantes :

- transmission à intervalles réguliers d'un signal de référence audit amplificateur ;
- numérisation de la réponse dudit amplificateur audit signal de référence, de façon à produire deux ensembles d'échantillons de référence AM/AM et AM/PM respectivement ;
- détermination de deux séries de polynômes représentatifs respectivement desdites caractéristiques AM/AM et AM/PM, à partir desdits échantillons, tenant compte d'une part de la dérivée seconde dudit polynôme, et d'autre part des distances entre lesdits échantillons et les points de la courbe définie par le polynôme ;
- mesure d'un paramètre représentatif du signal à transmettre ; et
- multiplication de prédistorsion dudit signal à transmettre, en fonction desdits polynômes et dudit paramètre représentatif.

Ledit paramètre représentatif peut notamment appartenir au groupe comprenant :

- la puissance dudit signal à transmettre ;
- le carré de la puissance dudit signal à transmettre;
- le module dudit signal à transmettre.

D'autres caractéristiques et avantages de l'invention apparaîtront plus clairement à la lecture de la description suivante d'un mode de réalisation préférentiel de l'invention, donné à titre de simple exemple illustratif et non limitatif, et des dessins annexés parmi lesquels :

- la figure 1 est un schéma synoptique simplifié du procédé de l'invention ;
- les figures 2, 3 et 4 illustrent des exemples de caractéristiques AM/AM en fontion du gain, calculées selon le procédé de la figure 1, dans les cas suivants :

  - $\rho = 0$ (correspondant à la méthode classique du spline) ;
  - $\rho = 10$ (correspondant à un lissage moyen) ;
  - $\rho = 100$ (correspondant à un lissage fort) ;

- la figure 5 illustre une caractéristique AM/AM théorique de l'amplificateur, en fontion de la puissance en sortie correspondant aux caractéristiques de l'amplificateur modélisées sur les figures 2 à 4 ;
- la figure 6 présente un dispositif mettant en oeuvre le procédé de la figure 1.

Le mode de réalisation préférentiel décrit ci-dessous s'applique au système TETRA. Ce système utilise la bande de fréquence 380 à 520 MHz, découpée en une série de canaux.

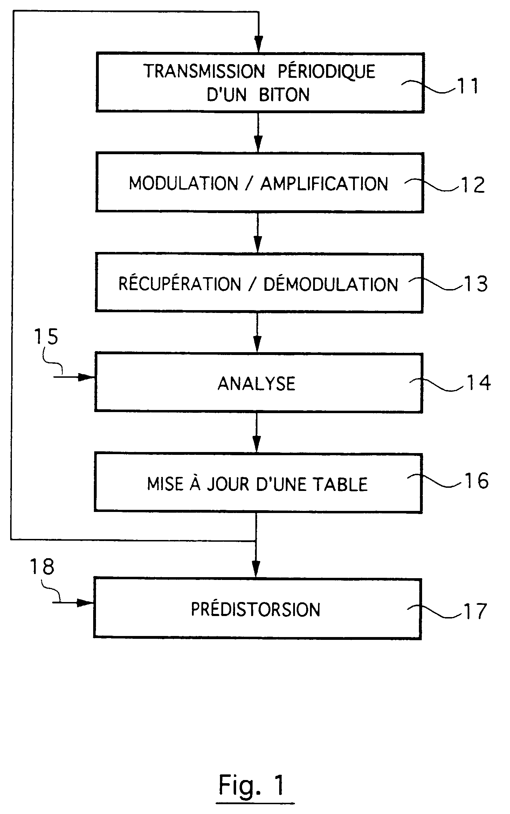

La figure 1 est un synoptique résumant le procédé de l'invention.

On transmet régulièrement 11 (toutes les 4 secondes) un signal de référence d'une durée de 6ms. Ce signal de référence est constitué pour chaque canal de deux fréquences pilotes (biton).

$$f_1 = f_c + 5 \text{ kHz}$$

$$f_2 = f_c + 6 \text{ kHz}$$

où $f_c$ est la fréquence centrale du canal.

On obtient ainsi une fréquence de battement de 1 kHz, qui permet de couvrir la bande de base de l'amplificateur, sans perturber les canaux adjacents.

Le biton est, de même que le reste du signal, modulé puis amplifié 12. Il subit ainsi les distorsions dues à l'amplification. Le biton amplifié est récupéré, démodulé et numérisé 13, puis analysé 14.

L'invention concerne essentiellement cette étape d'analyse. Comme déjà indiqué, cette analyse consiste à déterminer des caractéristiques AM/AM et AM/PM, à partir d'échantillons obtenus par numérisation du biton transmis.

Les figures 2 à 4 présentent trois caractéristiques AM/AM d'un amplificateur de puissance, dans différentes situations. Les croix illustrent les échantillons obtenus :

La figure 2 présente la caractéristique obtenue selon la technique connue du spline. On constate aisément que cette courbe est relativement "bosselée", du fait d'erreurs de mesure. Cela est dû au fait qu'on impose que cette courbe passe impérativement par tous les échantillons produits.

Les inventeurs ont constaté que de nombreuses sources d'erreurs pouvaient affecter ces échantillons. En conséquence, ceux-ci ne reflètent pas forcément la réalité de la prédistorsion. Il est donc préférable, bien que cela aille à l'encontre des habitudes de l'homme du métier, de lisser la courbe, en acceptant qu'elle ne passe pas exactement par chaque échantillon.

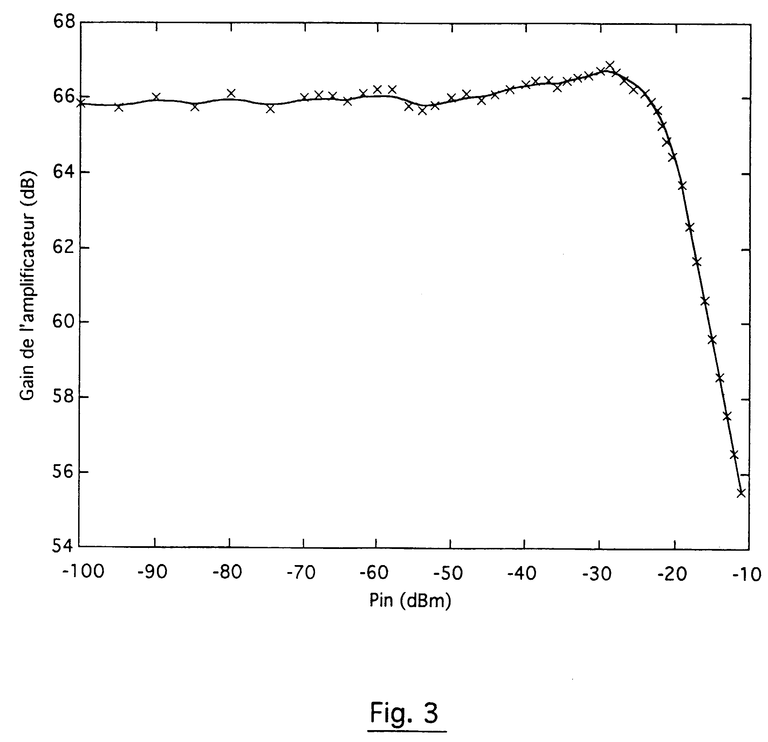

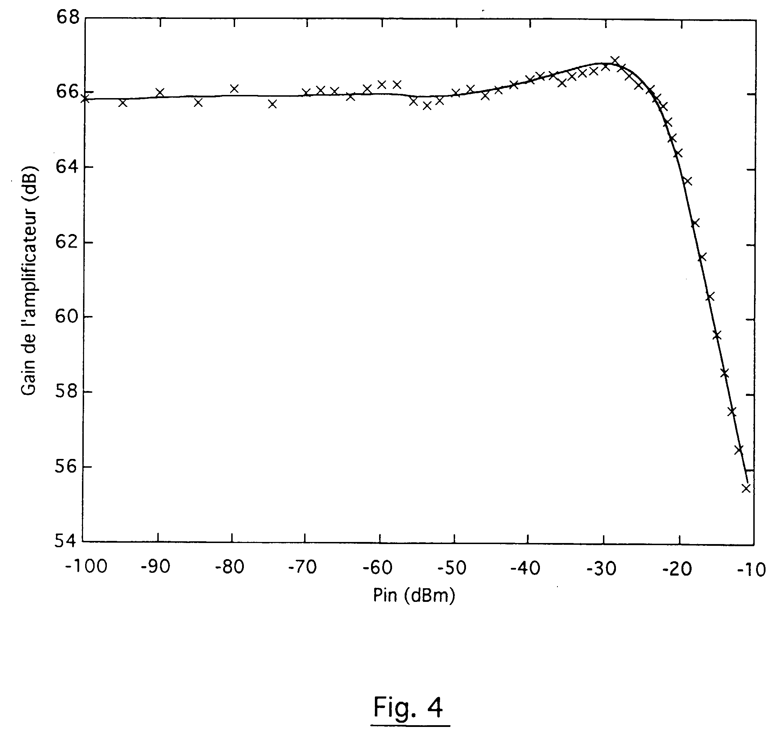

Les figures 3 et 4 illustrent deux caractéristiques de ce type. On constate que celles-ci sont "lissées", par rapport à la figure 2.

Le calcul mis en oeuvre selon l'invention pour obtenir ces courbes peut s'interpréter comme une amélioration de la technique du spline, tel que développée dans l'ouvrage de De Boor déjà cité.

Cette technique consiste à considérer quatre échantillons consécutifs, et à associer aux deux échantillons centraux la portion de courbe définie par le polynôme de puissance inférieure ou égale à trois passant par les quatre échantillons et présentant la dérivée seconde la plus faible.

L'invention propose de prendre en compte, de plus, les distance (affixes) de chaque point de cette portion de courbe également avec les deux échantillons considérés, et de minimiser également ces distances. Le calcule a donc pour but de minimiser une combinaison des trois paramètres suivants :

- dérivée seconde (w") dudit polynôme (w) ;
- distance dudit polynôme avec l'échantillon $P_1$ : $d_1^2 = (w_{(P1)} + w)^2$ ;
- distance dudit polynôme avec l'échantillon $P_2$ : $d_2^2 = (w_{(P2)} + w)^2$.

Selon les conditions d'émission, il peut être préférable de privilégier la dérivée seconde (passage par les échantillons ), ou le lissage. Les figures 3 et 4 illustrent deux situations, correspondant aux cas $\rho = 10$ et $\rho = 100$ respectivement.

Il apparaît clairement que, dans le figure 4, on a mis l'accent principalement sur le lissage.

La méthode de calcul et les justifications mathématiques de cette technique sont précisées dans l'annexe jointe à la présente demande. On indique notamment la façon selon laquelle le calcul peut être implanté en pratique, sous la forme d'une matrice pentadiagonale, pour par exemple 15 polynômes.

Le choix du facteur $\rho$ est fonction d'un ou plusieurs paramètres 15, tels que :

- l'erreur de quadrature;
- l'erreur de balance;
- la température;
- les défauts induits par le démodulateur;
- le bruit de phase ;
- le bruit global;
- la caractéristique moyenne de ladite courbe.

Les résultats de l'analyse 14 permettent la mise à jour 16 d'une table associant à un paramètre représentatif de la puissance 18 la prédistorsion 17 à appliquer.

La table de prédistorsion pourra ainsi avoir ses entrées graduées en module ou en puissance. pour la correction des non-linéarités à forte puissance on préférera une graduation en puissance car la zone concernée sera couverte de manière plus fine.

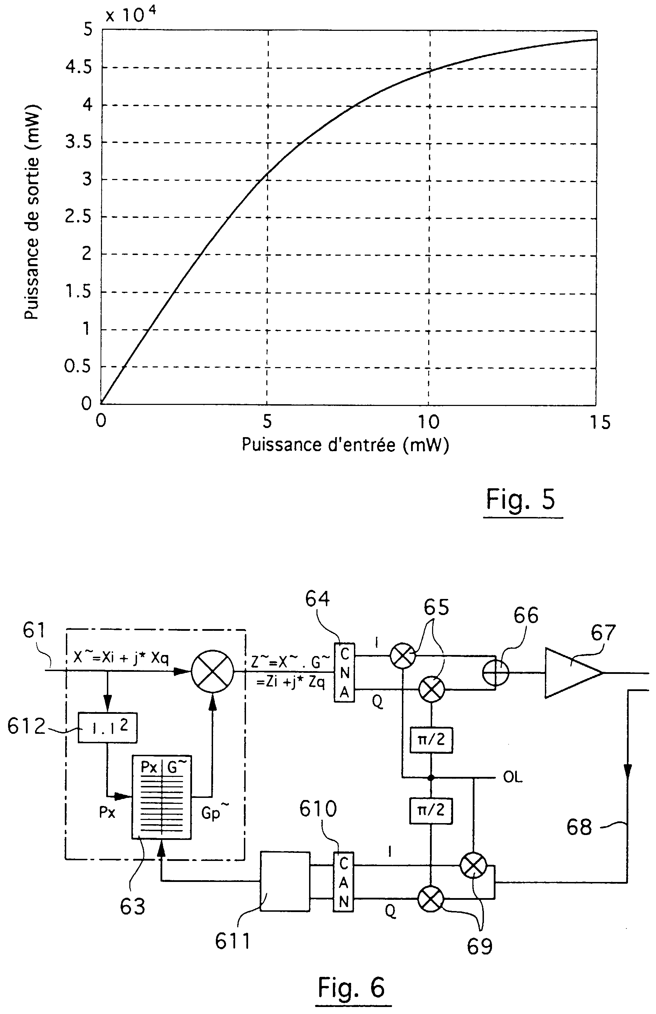

Dans le cas de l'amplificateur utilisé pour les stations de base du système TETRA, on se base sur un amplificateur théorique présentant des caractéristiques en tangente hyperbolique qui se rapproche des relevés expérimentaux du premier amplificateur, tel qu'illustré en figure 5.

Les conditions sont généralement les suivantes :

- Puissance maximum du signal TETRA : 0.007 mw soit -21.5 dBm;
- Gain théorique en puissance : 3,32.106 soit 65 dB;
- Puissance maximale de sortie : 24 W soit 44 dBm;
- Table de prédistorsion à 12 bits filtrée et graduée en puissance.

La figure 6 illustre le dispositif de l'invention pour un tel amplificateur notamment.

Le signal à transmettre 61 (y compris le biton de référence toutes les 4 secondes) $x- = x_i + j^* x_q$ alimente un multiplieur de prédistorsion 62, pour produire le signal :

$$z\sim = x\sim .g\sim = z_i + j*z_q$$

où G représente le facteur de prédistorsion, fournie par la table de valeurs 63.

Ensuite, classiquement, ce signal est converti du numérique en analogique 64, modulé 65 sur deux voies en quadrature I et Q qui sont additionnés 66, puis amplifiés 67.

Le signal biton amplifié est récupéré 68, démodulé 69 sur deux voies I et Q et numérisé 610, avant d'alimenter un processeur de traitement du signal 611, qui effectue le calcul des caractéristiques AM/AM et AM/PM décrit plus haut. Plus précisément, les opérations effectuées sont notamment l'acquisition de la non-linéarité, le calcul du modèle, puis la mise à jour de la table.

En fonction de ces caractéristiques, la table 63 est don mise à jour toutes les 4 secondes.

Cette table est adresse par un paramètre $P_x$ représentatif de la puissance du signal en entrée 61, tel que sa puissance au carré 612.

## ANNEXE

## SPLINES CUBIQUES D'INTERPOLATION ET D'AJUSTEMENT

Les fonctions splines cubiques sont les fonctions de $S_2$. Elles se caractérise donc ainsi :

i) w est un polynôme de degré inférieur ou égal à 3 sur chaque intervalle $]t_i, t_{i+1}[, i = 1,...,N-1$ ;
ii) w est un binôme du premier degré sur $]a, t_1[,]t_N, b[$ ;
iii) w" est continue sur $]a, b[$ ;

et:

iv) $w(t_i) = z_i, i = 1,...,N$ pour les splines d'interpolation ;
v) $w(t_i) + \rho_i(w'''(t_i^+) -w'''(t_i^+)) = z_i, i = 1,...,N$ pour les splines d'ajustement.

On présente ci-dessous une méthode de détermination de ces splines d'ajustement (les splines d'interpolation en représentant un cas particulier).

Soit $u_i$ la dérivée seconde de w en $t_i$. La dérivée seconde s'exprime dans l'intervalle $[t_i, t_{i+1}]$:

$$w"(t) = u_i \frac{t_{i+1} - t}{t_{i+1} - t_i} + u_{i+1} \frac{t - t_i}{t_{i+1} - t_i} \qquad (1)$$

car c'est un polynôme du premier degré. En posant $h_i = t_{i+1}, - t_i$, et en intégrant deux fois l'expression (1) sur $[t_i, t_{i+1}]$, on obtient :

$$w(t) = \frac{u_i}{6h_i} (t_{i+1} - t_i)^3 + \frac{u_{i+1}}{6h_i} (t - t_i)^3 + A_i t + B_i \qquad (2)$$

où $A_i$ et $B_i$ sont des constantes d'intégration. On cherche maintenant à exprimer ces constantes. Exprimée en $t_i$ et $t_{i+1}$, l'expression (2) fournit le système linéaire suivant:

$$\begin{cases} A_i t_i + B_i = w(t_i) - \frac{u_i}{6} h_i^2 \\ A_i t_{i+1} + B_i = w(t_{i+1}) - \frac{u_{i+1}}{6} h_i^2 \end{cases}$$

Sa résolution conduit à :

$$A_i = \frac{w(t_{i+1}) - w(t_i)}{h_i} - \frac{h_i}{6}(u_{i+1} - u_i) \tag{3}$$

$$B_i = \frac{t_{i+1}\,w(t_i) - t_i\,w(t_{i+1})}{h_i} - \frac{h_i}{6}(t_{i+1}\,u_i - t_i\,u_{i+1}) \tag{4}$$

L'expression (2) s'écrit alors, pout tout t de l'intervalle $[t_i, t_{i+1}]$ :

$$w(t) = \frac{u_i}{6}(t_{i+1} - t)\left(\frac{(t_{i+1} - t)^2}{h_i} - h_i\right) + \frac{u_{i+1}}{6}\left(\frac{(t - t_i)^2}{h_i} - h_i\right) + (t_{i+1} - t)\frac{w(t_i)}{h_i} + (t - t_i)\frac{w(t_{i+1})}{h_i}$$

Cette expression montre que le spline d'ajustement est entièrement connu en tout point de $]a, b[$ si l'on connaît ses valeurs et celles de sa dérivée seconde en chacun des points $t_i$. On montre maintenant que les valeurs du spline aux points $t_i$ peuvent s'exprimer en fonction des valeurs des dérivées secondes en ces mêmes points.

On a, en dérivant l'expression (1), pout tout t de l'intervalle $[t_i, t_{i+1}]$ :

$$\left(\frac{\rho_{i-1}}{h_{i-1}.h_{i-2}}\right)u_{i-2} + \left(\frac{h_{i-1}}{6} - \frac{\rho_i}{h_{i-1}}\left(\frac{1}{h_{i-1}} + \frac{1}{h_i}\right) - \frac{\rho_{i-1}}{h_{i-1}}\left(\frac{1}{h_{i-1}} + \frac{1}{h_{i-2}}\right)\right)u_{i-1}$$

$$+ \left(\frac{h_{i-1} + h_i}{3} + \frac{\rho_{i+1}}{h_i^2} + \rho_i\left(\frac{1}{h_i} + \frac{1}{h_{i-1}}\right)^2 + \frac{\rho_{i-1}}{h_{i-1}^2}\right)u_i$$

$$+ \left(\frac{h_i}{6} - \frac{\rho_{i+1}}{h_i}\left(\frac{1}{h_i} + \frac{1}{h_{i+1}}\right) - \frac{\rho_i}{h_i}\left(\frac{1}{h_i} + \frac{1}{h_{i-1}}\right)\right)u_{i+1} + \left(\frac{\rho_{i+1}}{h_i.h_{i+1}}\right)u_{i+2}$$

$$= \frac{z_{i+1} - z_i}{h_i} - \frac{z_i - z_{i-1}}{h_{i-1}}$$

où h représente la distance du point courant à l'affixe, et où $\rho$ est un paramètre prédéterminé.

On pose :

$$a_i = \frac{h_i + h_{i+1}}{3} + \frac{\rho_{i+2}}{h_{i+1}^2} + \frac{\rho_i}{h_i^2} + \rho_{i+1}\left(\frac{1}{h_{i+1}} + \frac{1}{h_i}\right)^2$$

$$b_i = \frac{h_{i+1}}{6} - \frac{\rho_{i+1}}{h_{i+1}}\left(\frac{1}{h_{i+1}} + \frac{1}{h_i}\right) - \frac{\rho_{i+2}}{h_{i+1}}\left(\frac{1}{h_{i+2}} + \frac{1}{h_{i+1}}\right)$$

$$c_i = \frac{\rho_{i+2}}{h_{i+1}.h_{i+2}}$$

$$d_i = \frac{z_{i+2} - z_{i+1}}{h_{i+1}} - \frac{z_{i+1} - z_i}{h_i}$$

On a alors :

$$c_{i-3}.u_{i-2} + b_{i-2}.u_{i-1} + a_{i-1}.u_i + b_{i-1}.u_{i+1} + c_{i-1}.u_{i+2} = \frac{z_{i+1} - z_i}{h_i} - \frac{z_i - z_{i-1}}{h_{i-1}} = d_{i-1}$$

Le calcul de la courbe globale peut donc s'écrire à l'aide d'une matrice pentadioganale, sous la forme suivante :

$$\begin{bmatrix} a_1 & b_1 & c_1 \\ b_1 & a_2 & b_2 & c_2 \\ c_1 & b_2 & a_3 & b_3 & c_3 \\ & c_2 & b_3 & a_4 & b_4 & c_4 \\ \\ \\ & & & & & & c_{n-5} & b_{n-4} & a_{n-3} & b_{n-3} \\ & & & & & & & c_{n-4} & b_{n-3} & a_{n-2} \end{bmatrix} \begin{bmatrix} u_2 \\ u_3 \\ u_4 \\ u_5 \\ \\ \\ u_{n-2} \\ u_{n-3} \end{bmatrix} = \begin{bmatrix} d_1 \\ d_2 \\ d_3 \\ d_4 \\ \\ \\ d_{n-3} \\ d_{n-2} \end{bmatrix}$$

## Revendications

1. Procédé de modélisation des caractéristiques AM/AM et AM/PM d'un amplificateur, comprenant les étapes suivantes :

   - transmission (11) d'un signal de référence audit amplificateur;
   - numérisation (12) de la réponse dudit amplificateur audit signal de référence, de façon à produire deux ensembles d'échantillons de référence AM/AM et AM/PM respectivement;
   - détermination (14) de deux séries de polynômes représentatifs respectivement desdites caractéristiques AM/AM et AM/PM, à partir desdits échantillons,

   caractérisé en ce que la détermination de chacun desdits polynômes tient compte d'une part de la dérivée seconde dudit polynôme, et d'autre part des distances entre lesdits échantillons et les points de la courbe définie par le polynôme.

2. Procédé selon la revendication 1, caractérisé en ce que chacun desdits polynômes (w) est déterminé pour deux échantillons consécutifs ($P_1$ et $P_2$), et minimise une combinaison linéaire des trois paramètres suivants :

   - dérivée seconde (w") dudit polynôme (w) ;
   - distance dudit polynôme avec l'échantillon $P_1$ : $d_1^2 = (w_{(P1)} + w)^2$ ;
   - distance dudit polynôme avec l'échantillon $P_2$ : $d_2^2 = (w_{(P2)} + w)^2$.

3. Procédé selon la revendication 2, caractérisé en ce que ladite combinaison linéaire s'écrit :

$$J = \int_{x_1}^{x_N} (w''(x))^2 dx + \frac{1}{\rho}\sum_{1}^{N} w(x_i) - y_i)^2$$

où $\rho$ est un coefficient de pondération.

4. Procédé selon la revendication 3, caractérisé en ce que ledit coefficient de pondération $\rho$ varie en fonction d'au moins un des paramètres (15) appartenant au groupe comprenant :

- l'erreur de quadrature;
- l'erreur de balance;
- la température ;
- les défauts induits par le démodulateur;
- le bruit de phase ;
- le bruit global;
- la caractéristique moyenne de ladite courbe.

5. Procédé selon l'une quelconque des revendications 2 à 4, caractérisé en ce que ladite détermination desdits polynômes met en oeuvre une matrice de calcul pentadiagonale.

6. Procédé selon l'une quelconque des revendications 1 à 5, caractérisé en ce que ledit signal de référence est constitué de deux fréquences pilotes émises régulièrement, et séparées par une bande de fréquence de battement choisie de façon à couvrir une bande de fréquence très étroite, correspondant sensiblement à la réponse en bande de base dudit amplificateur

7. Procédé selon l'une quelconque des revendications 1 à 6, caractérisé en ce que ladite détermination desdits polynômes est utilisée pour mettre à jour une table de prédistorsion (16).

8. Dispositif de modélisation des caractéristiques AM/AM et AM/PM d'un amplificateur, à partir d'un signal de référence transmis audit amplificateur, comprenant :

   - des moyens (611) de numérisation de la réponse dudit amplificateur audit signal de référence, délivrant deux ensembles d'échantillons de référence AM/AM et AM/PM respectivement ; et
   - des moyens (611) de détermination de deux séries de polynômes représentatifs respectivement desdites caractéristiques AM/AM et AM/PM, à partir desdits échantillons,

   caractérisé en ce que lesdits moyens de détermination de chacun desdits polynômes tiennent compte d'une part de la dérivée seconde dudit polynôme, et d'autre part des distances entre lesdits échantillons et les points de la courbe définie par le polynôme.

9. Procédé de prédistorsion pour un amplificateur d'un signal modulé selon une modulation à enveloppe non constante, à partir d'une modélisation des caractéristiques AM/AM et AM/PM dudit amplificateur,
   caractérisé en ce qu'il comprend les étapes suivantes :

   - transmission (11) à intervalles réguliers d'un signal de référence audit amplificateur ;
   - numérisation (13) de la réponse dudit amplificateur audit signal de référence, de façon à produire deux ensembles d'échantillons de référence AM/AM et AM/PM respectivement ;
   - détermination (14) de deux séries de polynômes représentatifs respectivement desdites caractéristiques AM/AM et AM/PM, à partir desdits échantillons, tenant compte d'une part de la dérivée seconde dudit polynôme, et d'autre part des distances entre lesdits échantillons et les points de la courbe définie par le polynôme ;
   - mesure d'un paramètre (18) représentatif du signal à transmettre ; et
   - multiplication de prédistorsion (17) dudit signal à transmettre, en fonction desdits polynômes et dudit paramètre représentatif.

10. Procédé selon la revendication 9, caractérisé en ce que ledit paramètre représentatif (18) appartient au groupe comprenant :

   - la puissance dudit signal à transmettre;
   - le carré de la puissance dudit signal à transmettre ;
   - le module dudit signal à transmettre.

TRANSMISSION PÉRIODIQUE
D'UN BITON — 11

MODULATION / AMPLIFICATION — 12

RÉCUPÉRATION / DÉMODULATION — 13

15 → ANALYSE — 14

MISE À JOUR D'UNE TABLE — 16

18 → PRÉDISTORSION — 17

Fig. 1

10

Fig. 2

Fig. 3

Fig. 4

Fig. 5

Fig. 6

**Office européen des brevets**

**RAPPORT DE RECHERCHE EUROPEENNE**

Numéro de la demande

EP 97 40 1870

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | LOHTIA ET AL.: "Power amplifier linearization using cubic spline interpolation" 43RD IEEE VEHICULAR TECHNOLOGY CONFERENCE, 18 - 20 mai 1993, NEW YORK, US, pages 676-679, XP000393273 * abrégé * * page 677, colonne de droite, alinéa 1 * | 1,8-10 | H04L27/36 |
| A | STAPLETON & CAVERS: "A new technique for adaptation of linearizing predistorters" 41ST IEEE VEHICULAR TECHNOLOGY CONFERENCE, 19 - 22 mai 1991, INSTITUTE OF ELECTRICAL AND ELECTRONICS ENGINEERS, pages 753-758, XP000260272 * page 753, colonne de gauche, alinéa 3 * * page 756, colonne de gauche, alinéa 4 * | 1-10 | |
| A | STAPLETON ET AL.: "Simulation and analysis of an adaptive predistorter utilizing a complex spectral convolution" IEEE TRANSACTIONS ON VEHICULAR TECHNOLOGY, vol. 41, no. 4, 1 novembre 1992, NEW YORK US, pages 387-394, XP000362352 * abrégé * * page 387, colonne de droite, alinéa 5 * | 1-10 | **DOMAINES TECHNIQUES RECHERCHES (Int.Cl.6)** H04L H03F |
| A | ZWILLINGER: "Standard Mathematical Tables and Forulae" 1996 , CRC PRESS , BOCA RATON, US XP002030127 * page 676 - page 682 * | 1-3,8,9 | |

Le présent rapport a été établi pour toutes les revendications

| Lieu de la recherche | Date d'achèvement de la recherche | Examinateur |
|---|---|---|
| LA HAYE | 7 novembre 1997 | Scriven, P |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03 82 (P04C02)